# EUROPEAN PATENT APPLICATION

(11) **EP 4 836 651 A1**
(43) Date of publication of application: **04.11.2026**
(21) Application number: 26167822.1
(22) Date of filing: 25.03.2026
(51) Int. Cl.: H10K 59/122, H10K 59/124, H10K 59/35, H10K 59/38, H10K 59/80

(54) **DISPLAY APPARATUS AND ELECTRONIC APPARATUS INCLUDING THE DISPLAY APPARATUS**

(30) Priority: 28.04.2025 KR 20250055804
(71) Applicant: Samsung Display Co., Ltd., Yongin-si, Gyeonggi-do 17113 (KR)
(72) Inventor: KIM, Taeho, 17113 Yongin-si (KR); KWON, Ohjeong, 17113 Yongin-si (KR); KIM, Sujeong, 17113 Yongin-si (KR); SON, Jongho, 17113 Yongin-si (KR); JEONG, Seungyeon, 17113 Yongin-si (KR)
(74) Representative: Marks & Clerk LLP

(57) **Abstract**

A display apparatus includes an insulating layer including a recessed portion including an inclined portion and a bottom surface portion, light-emitting diodes each including a pixel electrode having at least a portion on the inclined portion, an emission layer, and a counter electrode, and a pixel defining layer disposed between the pixel electrode and the counter electrode and covering a portion of the pixel electrode. The plurality of light-emitting diodes include a first light-emitting diode having a first peak wavelength within a first wavelength range, a second light-emitting diode having a second peak wavelength within a second wavelength range, and a third light-emitting diode having a third peak wavelength within a third wavelength range. The pixel defining layer includes a material having a maximum absorption wavelength outside each of the first wavelength range, the second wavelength range, and the third wavelength range.

## Description

### BACKGROUND

### 1. Field

One or more embodiments relate to a display apparatus and an electronic apparatus including the display apparatus.

### 2. Description of the Related Art

A display apparatus is a device that visually displays data. A display apparatus is sometimes used as a display portion for small products such as mobile phones, and sometimes as a display portion for large products such as televisions.

A display apparatus includes a plurality of pixels that receive an electrical signal and emit light to display an image to the outside. Each pixel includes a light-emitting element, for example, an organic light-emitting display apparatus includes an organic light-emitting diode (OLED) as a light-emitting element.

Recently, as the uses of display apparatuses have become more diverse, various designs are being attempted to improve the quality of display apparatuses.

### SUMMARY

One or more embodiments include a display apparatus that implements images of excellent quality and an electronic apparatus. However, the above objective is an example, and the scope of the disclosure is not limited by the above objective.

Additional aspects will be set forth in part in the description which follows and, in part, will be apparent from the description, or may be learned by practice of the presented embodiments of the disclosure.

According to one or more embodiments, a display apparatus includes a substrate, an insulating layer disposed on the substrate and including a recessed portion including an inclined portion and a bottom surface portion, a plurality of light-emitting diodes each including a pixel electrode having at least a portion disposed on the inclined portion of the recessed portion of the insulating layer, an emission layer on the pixel electrode, and a counter electrode on the emission layer, and a pixel defining layer disposed between the pixel electrode and the counter electrode and covering a portion of the pixel electrode, wherein the plurality of light-emitting diodes include a first light-emitting diode emitting red light having a first peak wavelength within a first wavelength range, a second light-emitting diode emitting green light having a second peak wavelength within a second wavelength range, and a third light-emitting diode emitting blue light having a third peak wavelength within a third wavelength range, and the pixel defining layer includes a material having a maximum absorption wavelength (λmax) outside each of the first wavelength range, the second wavelength range, and the third wavelength range.

In an embodiment, the pixel defining layer may include a material having a maximum absorption wavelength (λmax) in a fourth wavelength range between the first wavelength range and the second wavelength range.

In an embodiment, the fourth wavelength range may be about 550 nm to about 600 nm.

In an embodiment, the pixel defining layer may include a phthalocyanine-based compound, boron-dipyrromethene (BODIPY), or a tetraazaporphyrin-based compound.

In an embodiment, the first wavelength range may be about 600 nm to about 630 nm.

In an embodiment, the second wavelength range may be about 510 nm to about 540 nm.

In an embodiment, the third wavelength range may be about 440 nm to about 470 nm.

In an embodiment, the display apparatus may further include an encapsulation layer disposed on the first light-emitting diode, the second light-emitting diode, and the third light-emitting diode, and a polarization layer disposed on the encapsulation layer.

In an embodiment, the display apparatus may further include an encapsulation layer disposed on the first light-emitting diode, the second light-emitting diode, and the third light-emitting diode, and a color filter layer disposed on the encapsulation layer.

In an embodiment, the pixel electrode may include a first portion disposed on the bottom surface portion of the recessed portion and a second portion disposed on the inclined portion, and the pixel defining layer may cover the second portion and expose at least a portion of the first portion.

According to one or more embodiments, a display apparatus includes a substrate, an insulating layer disposed on the substrate and including a recessed portion including an inclined portion and a bottom surface portion, a pixel electrode including a first portion arranged on the bottom surface portion and a second portion arranged on the inclined portion, a pixel defining layer covering the second portion of the pixel electrode and defining an opening exposing at least a portion of the first portion of the pixel electrode, an emission layer disposed on the pixel electrode, and a counter electrode disposed on the emission layer, wherein the pixel defining layer transmits light in a first wavelength range of about 600 nm to about 630 nm, light in a second wavelength range of about 510 nm to about 540 nm, and light in a third wavelength range of about 440 nm to about 470 nm, and includes a material having a maximum absorption wavelength (λmax) outside each of the first wavelength range, the second wavelength range, and the third wavelength range.

In an embodiment, the pixel defining layer may include a material having a maximum absorption wavelength (λmax) in a fourth wavelength range between the first wavelength range and the second wavelength range.

In an embodiment, the fourth wavelength range may be about 550 nm to about 600 nm.

In an embodiment, the pixel defining layer may include a phthalocyanine-based compound, BODIPY, or a tetraazaporphyrin-based compound.

In an embodiment, the display apparatus may further include an encapsulation layer disposed on the counter electrode, and a polarization layer disposed on the encapsulation layer.

In an embodiment, the display apparatus may further include an encapsulation layer disposed on the counter electrode, and a color filter layer disposed on the encapsulation layer.

According to one or more embodiments, an electronic apparatus includes a display apparatus, and a processor which provides an image data signal and an input control signal to the display apparatus, wherein the display apparatus includes a substrate, an insulating layer disposed on the substrate and including an inclined portion, a plurality of light-emitting diodes each including a pixel electrode having at least a portion disposed on the inclined portion of the insulating layer, an emission layer on the pixel electrode, and a counter electrode on the emission layer, and a pixel defining layer disposed between the pixel electrode and the counter electrode and covering a portion of the pixel electrode, wherein the plurality of light-emitting diodes include a first light-emitting diode emitting red light having a first peak wavelength within a first wavelength range, a second light-emitting diode emitting green light having a second peak wavelength within a second wavelength range, and a third light-emitting diode emitting blue light having a third peak wavelength within a third wavelength range, and the pixel defining layer includes a material having a maximum absorption wavelength (λmax) outside each of the first wavelength range, the second wavelength range, and the third wavelength range.

In an embodiment, the first wavelength range may be about 600 nm to about 630 nm, the second wavelength range may be about 510 nm to about 540 nm, and the third wavelength range may be about 440 nm to about 470 nm.

In an embodiment, the pixel defining layer may include a material having a maximum absorption wavelength (λmax) in a range of about 550 nm to about 600 nm.

In an embodiment, the pixel defining layer may include a phthalocyanine-based compound, BODIPY, or a tetraazaporphyrin-based compound.

At least some of the above and other features of the invention are set out in the claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a plan view schematically illustrating a display apparatus according to an embodiment;
FIG. 2 is an equivalent circuit diagram of a pixel of a display apparatus, according to an embodiment;
FIG. 3 is a cross-sectional view schematically illustrating a display area of a display apparatus according to an embodiment;
FIG. 4 is a cross-sectional view schematically illustrating a display area of a display apparatus according to an embodiment;
FIG. 5 is a cross-sectional view schematically illustrating a display area of a display apparatus according to an embodiment;
FIG. 6 is a graph illustrating emission spectra and a Y-bar function of red light, green light, and blue light, according to an embodiment;
FIG. 7 is a table illustrating a maximum absorption wavelength for each colorant;
FIG. 8 is a graph illustrating Specular Component Included (SCI) reflectance versus the light efficiency of comparative examples and embodiments;
FIG. 9 is a table illustrating the reflectance and maximum absorption wavelengths when the light efficiency of the comparative examples and the embodiments of FIG. 8 is 106%;
FIG. 10 is a block diagram of an electronic apparatus according to an embodiment; and
FIG. 11 is a schematic diagram illustrating various electronic apparatuses according to one or more embodiments of the present disclosure.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are described herein, by referring to the figures, to explain aspects of the present disclosure. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the disclosure allows for various changes and numerous embodiments, particular embodiments will be illustrated in the drawings and described in detail in the written description. The effects and features of the disclosure, and ways to achieve the same will become apparent by referring to embodiments that will be described later in detail with reference to the drawings. However, the disclosure is not limited to the following embodiments but may be embodied in various forms.

Hereinafter, embodiments will be described in detail with reference to the accompanying drawings, and in the description with reference to the drawings, like reference numerals refer to like elements and redundant descriptions thereof will be omitted.

It will be understood that although the terms "first," "second," and the like may be used herein to describe various elements, these elements should not be limited by these terms. These terms are used to distinguish one element from another.

In the embodiments below, an x-axis, a y-axis, and a z-axis are not limited to three axes on a rectangular coordinates system but may be construed as including these axes. For example, an-x axis, a y-axis, and a z-axis may be at right angles or may also indicate different directions from one another, which are not at right angles.

Singular expressions, unless defined otherwise in contexts, include plural expressions.

In the embodiments below, terms such as "include" or "have" indicate that the features or elements described in the specification exist, and do not exclude in advance the possibility of adding one or more other features or elements.

In the embodiments below, it will be understood when a portion such as a layer, an area, or an element is referred to as being "on" or "above" another portion, it may be directly on or above the other portion, or an intervening portion may also be present.

The terms "about" or "approximately" as used herein are inclusive of the stated value and include a suitable range of deviation for the particular value as determined by one of ordinary skill in the art, considering the measurement in question and the error associated with measurement of the particular quantity. The terms "about" or "approximately" can mean within one or more standard deviations, or within ± 30%, 20%, 10%, 5% of the stated value, for example.

The term "substantially," as used herein, means approximately or actually. The term "substantially simultaneously" means approximately or actually simultaneously. In some aspects, in the drawings, for convenience of description, sizes of elements may be exaggerated or contracted. For example, since sizes and thicknesses of elements in the drawings are arbitrarily illustrated for convenience of description, the following embodiments are not limited thereto.

When an embodiment is implementable in another manner, a predetermined process order may be different from a described one. For example, two processes that are consecutively described may be substantially simultaneously performed or may be performed in an opposite order to the described order.

In the embodiments below, when layers, regions, or elements are described as being connected, this indicates not only a case where layers, regions, and elements are directly connected but also a case where layers, regions, and elements are indirectly connected to each other, with other layers, regions, and elements therebetween. For example, herein, when layers, regions, or elements are described as being electrically connected, this indicates not only a case where layers, regions, and elements are directly electrically connected but also a case where layers, regions, and elements are indirectly electrically connected to each other, with other layers, regions, and elements therebetween.

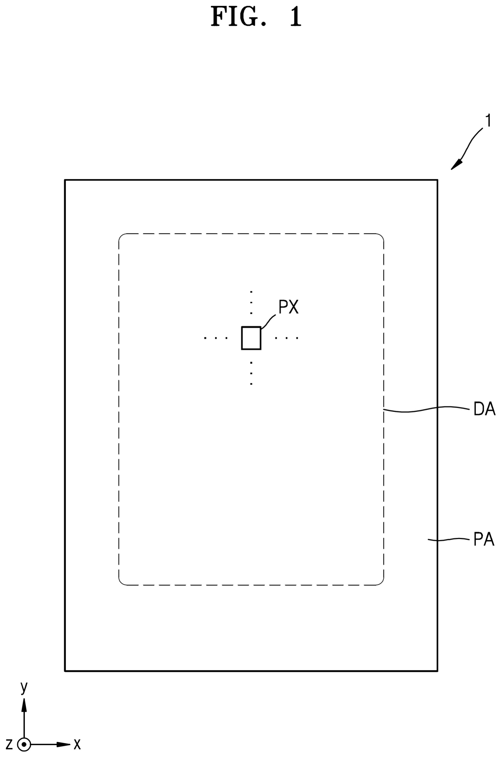

FIG. 1 is a plan view schematically illustrating a display apparatus 1 according to an embodiment.

Referring to FIG. 1, the display apparatus 1 manufactured according to an embodiment may include a display area DA and a peripheral area PA located outside the display area DA. The display apparatus 1 may provide an image through an array of a plurality of pixels PX arranged two-dimensionally in the display area DA. Each pixel PX may include a display element such as a light-emitting element. Each pixel PX may emit light of, for example, red, green, blue or white.

The peripheral area PA may be an area that does not provide an image and may completely or partially surround the display area DA. In the peripheral area PA, drivers for providing electrical signals or power to pixel circuits corresponding to the pixels PX may be arranged. The peripheral area PA may be configured with pads, which are areas where electronic components or printed circuit boards may be electrically connected.

FIG. 1 illustrates, but is not limited to, a polygon (e.g., a rectangle) having a length in a first direction (e.g., a x-direction) of the display area DA, which is less than a length thereof in a second direction (e.g., a y-direction). In an embodiment, the display area DA may be a polygon (e.g., a rectangle), the length of which in the second direction (e.g., the y-direction) is less than the length thereof in the first direction (e.g., the x-direction). While FIG. 1 illustrates the display area DA which is approximately a rectangle, the disclosure is not limited thereto. In an embodiment, the display area DA may be N-gonal (N is a natural number greater than or equal to 3), or may have various shapes such as a circle or an oval. In an embodiment, the display area DA may be a polygon with rounded corners.

Hereinafter, the display apparatus 1 including an organic light-emitting diode OLED as a light-emitting element is described, but the display apparatus 1 of the disclosure is not limited thereto. In an embodiment, the display apparatus 1 may be a light-emitting display device including an inorganic light-emitting diode, i.e., an inorganic light-emitting display. The inorganic light-emitting diode may include a PN diode including inorganic semiconductor-based materials. When a voltage is applied to a PN junction diode in a forward direction, holes and electrons are injected, and energy generated by recombination of the holes and the electrons is converted into light energy to emit light of a certain color. The inorganic light-emitting diode described herein may have a width of several to several hundred micrometers, and in some embodiments, the inorganic light-emitting diode may be referred to as a micro LED. As another embodiment, the display apparatus 1 may be a quantum dot light-emitting display.

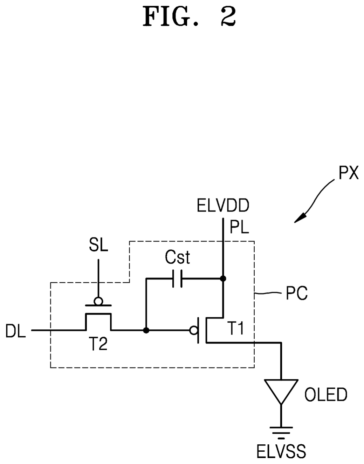

FIG. 2 is an equivalent circuit diagram of a pixel PX of the display apparatus 1, according to an embodiment.

Each pixel PX may include a pixel circuit PC and a display element connected to the pixel circuit PC, such as the organic light-emitting diode OLED. The pixel circuit PC may include a first transistor T1, a second transistor T2, and a storage capacitor Cst. Each pixel PX may emit light of, for example, red, green, blue or white color via the organic light-emitting diode OLED.

The second transistor T2 may be a switching thin film transistor, connected to a scan line SL and a data line DL, and may be configured to transmit a data voltage input from the data line DL, to the first transistor T1, based on a switching voltage input from the scan line SL. The storage capacitor Cst may be connected to the second transistor T2 and a driving voltage line PL, and may store a voltage corresponding to a difference between a voltage received from the second transistor T2 and a first power supply voltage ELVDD supplied to the driving voltage line PL.

The first transistor T1 may be a driving transistor, may be connected to the driving voltage line PL and the storage capacitor Cst, and may control a driving current flowing through the organic light-emitting diode OLED from the driving voltage line PL in response to a voltage value stored in the storage capacitor Cst. The organic light-emitting diode OLED may emit light with a certain brightness according to the driving current. A common electrode (e.g., cathode) of the organic light-emitting diode OLED may receive a second power supply voltage ELVSS.

Although FIG. 2 illustrates the pixel circuit PC including two transistors and one storage capacitor, the disclosure is not limited thereto. The number of transistors and the number of storage capacitors may vary depending on the design of the pixel circuit PC. For example, the pixel circuit PC may include four or five or more transistors in addition to the two transistors described herein.

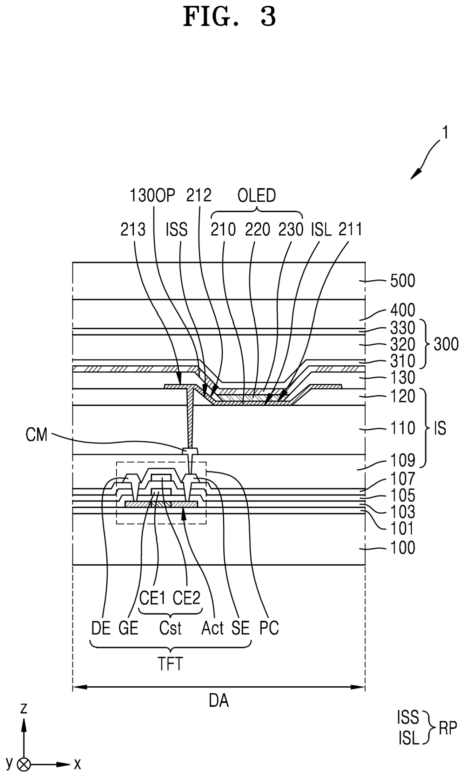

FIG. 3 is a cross-sectional view schematically illustrating a display area of a display apparatus according to an embodiment;

Referring to FIG. 3, the display apparatus 1 may include a substrate 100, the pixel circuit PC, the organic light-emitting diode OLED electrically connected to the pixel circuit PC, an insulating layer IS, and an encapsulation layer 300. In an embodiment, the display apparatus 1 may further include a touch sensor layer 400 and/or a polarization layer 500. In an embodiment, the display apparatus 1 may further include the touch sensor layer 400 and/or a color filter layer.

The display apparatus 1 may include the organic light-emitting diode OLED arranged in the display area DA. The organic light-emitting diode OLED may be disposed on the substrate 100, and the pixel circuit PC may be arranged between the substrate 100 and the organic light-emitting diode OLED. As an example, FIG. 3 illustrates a thin film transistor TFT and the storage capacitor Cst as some components of the pixel circuit PC.

The substrate 100 may include glass, metal, or polymer resin. The polymer resin may include polyethersulphone, polyacrylate, polyetherimide, polyethylene naphthalate, polyethylene terephthalate, polyphenylene sulfide, polyarylate, polyimide, polycarbonate, cellulose acetate propionate or a mixture thereof. In an embodiment, the substrate 100 may have a multilayer structure including at least two base layers each including a polymer resin as described herein and an inorganic layer positioned between the base layers.

A buffer layer 101 may be arranged on the substrate 100. The buffer layer 101 may reduce or block the penetration of foreign substances, moisture or external air from below the substrate 100 into a semiconductor layer Act of the thin film transistor TFT, and may provide a flat surface on the substrate 100. The buffer layer 101 may include an inorganic insulating material such as, for example, silicon oxide, silicon oxynitride, or silicon nitride, and may be formed as a single layer or multilayer structure including the materials described herein.

The thin film transistor TFT may be arranged on the buffer layer 101. The thin film transistor TFT may include the semiconductor layer Act, a gate electrode GE, a drain electrode DE, and a source electrode SE. In an embodiment, the thin film transistor TFT of FIG. 3 may correspond to the first transistor T1 of the pixel circuit PC of FIG. 2.

The semiconductor layer Act may include polysilicon (poly-Si). Alternatively, the semiconductor layer Act may include amorphous silicon (a-Si), an oxide semiconductor, an organic semiconductor, or the like. The semiconductor layer Act may include a channel region and a drain region and a source region respectively disposed on both sides of the channel region. The channel region of the semiconductor layer Act may overlap with the gate electrode GE.

The gate electrode GE may include a low-resistance metal material. The gate electrode GE may include a conductive material including molybdenum (Mo), aluminium (Al), copper (Cu), titanium (Ti), or the like, and may be formed as a multilayer or single layer including the above materials.

The first gate insulating layer 103 between the semiconductor layer Act and the gate electrode GE may include an inorganic insulating material such as, for example, silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnOₓ). Zinc oxide (ZnOₓ) may include zinc oxide (ZnO) and/or zinc peroxide (ZnO₂).

A second gate insulating layer 105 may be provided which covers the gate electrode GE. Similar to the first gate insulating layer 103, the second gate insulating layer 105 may include an inorganic insulating material such as, for example, silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnOₓ). Zinc oxide (ZnOₓ) may include zinc oxide (ZnO) and/or zinc peroxide (ZnO₂).

An upper electrode CE2 of the storage capacitor Cst may be arranged on the second gate insulating layer 105. The upper electrode CE2 of the storage capacitor Cst may overlap with the gate electrode GE. The upper electrode CE2 of the gate electrode GE and the storage capacitor Cst overlapping with the second gate insulating layer 105 therebetween may form the storage capacitor Cst. That is, the gate electrode GE may function as a lower electrode CE1 of the storage capacitor Cst.

In an embodiment, the storage capacitor Cst and the thin film transistor TFT may overlap each other. In some embodiments, the storage capacitor Cst may be formed not to overlap the thin film transistor TFT.

The upper electrode CE2 of the storage capacitor Cst may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may be a single layer or multiple layers of the materials described herein.

The interlayer insulating layer 107 may cover the upper electrode CE2 of the storage capacitor Cst. The interlayer insulating layer 107 may include silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnOₓ). Zinc oxide (ZnOₓ) may be zinc oxide (ZnO), and/or zinc peroxide (ZnO₂). The interlayer insulating layer 107 may be a single layer or multiple layers including the inorganic insulating material described herein.

The drain electrode DE and the source electrode SE may each be positioned on the interlayer insulating layer 107. The drain electrode DE and the source electrode SE may be connected to a drain region and a source region of the semiconductor layer Act, respectively, through contact holes formed in insulating layers therebelow. The drain electrode DE and the source electrode SE may include a material having good conductivity. The drain electrode DE and the source electrode SE may include a conductive material including molybdenum (Mo), aluminium (Al), copper (Cu), titanium (Ti), or the like, and may be formed as a multilayer or single layer including the above materials. As an example, the drain electrode DE and the source electrode SE may have a multilayer structure of Ti/Al/Ti.

The display apparatus 1 may include the insulating layer IS covering the thin film transistor TFT. The insulating layer IS may be an insulating structure including a plurality of insulating layers. For example, the insulating layer IS may include a first via insulating layer 109, a second via insulating layer 110, and a third via insulating layer 120.

The first via insulating layer 109 may cover the drain electrode DE and the source electrode SE. The first via insulating layer 109 may be a single layer or a plurality of insulating layers having a flat upper surface.

A connection electrode CM may be arranged on the first via insulating layer 109. The connection electrode CM may electrically connect a pixel electrode 210 of the organic light-emitting diode OLED to the thin film transistor TFT to.

The second via insulating layer 110 may be arranged on the first via insulating layer 109 and cover the connection electrode CM. The second via insulating layer 110 may be a single layer or a plurality of insulating layers having a flat upper surface.

The third via insulating layer 120 may be arranged on the second via insulating layer 110. The third via insulating layer 120 may include an inclined surface. The third via insulating layer 120 may include an opening to expose a portion of the upper surface of the second via insulating layer 110.

The insulating layer IS may include a recessed portion RP including a bottom surface portion ISL and an inclined portion ISS inclined from the bottom surface portion ISL. In an embodiment, the recessed portion RP of the insulating layer IS may be formed by the second via insulating layer 110 and the third via insulating layer 120. For example, the upper surface of the second via insulating layer 110 may form the bottom surface portion ISL of the recessed portion RP, and the inclined surface of the third via insulating layer 120 may form the inclined portion ISS of the recessed portion RP.

In an embodiment, the first via insulating layer 109, the second via insulating layer 110, and the third via insulating layer 120 may include the same or similar materials. In an embodiment, the first via insulating layer 109, the second via insulating layer 110, and the third via insulating layer 120 may include different materials. Each of the first via insulating layer 109, the second via insulating layer 110, and the third via insulating layer 120 may include an organic insulating material, for example, a general-purpose polymer including polymethylmethacrylate (PMMA) or polystyrene (PS), a polymer derivative having a phenol group, an acrylic polymer, an imide polymer, an aryl ether polymer, an amide polymer, a fluorinated polymer, a p-xylene polymer, a vinyl alcohol polymer, and a blend thereof.

The organic light-emitting diode OLED may be arranged as a display element on the insulating layer IS. The organic light-emitting diode OLED may include a stacked structure of the pixel electrode 210, an emission layer 220, and a counter electrode 230. The organic light-emitting diode OLED may emit, for example, red, green, or blue light, or may emit red, green, blue, or white light. The organic light-emitting diode OLED may emit light through an emission area.

The organic light-emitting diode OLED may be electrically connected to the thin film transistor TFT through contact holes formed in the insulating layer IS (e.g., the first via insulating layer 109, the second via insulating layer 110, and the third via insulating layer 120) and through the connection electrode CM.

The pixel electrode 210 may be arranged on the insulating layer IS. At least a portion of the pixel electrode 210 may be arranged on the bottom surface portion ISL and the inclined portion ISS of the recessed portion RP. For example, the pixel electrode 210 may include a first portion 211 positioned on the bottom surface portion ISL of the recessed portion RP, and a second portion 212 positioned on the inclined portion ISS of the recessed portion RP. For example, the second portion 212 of the pixel electrode 210 may be inclined from the first portion 211. The second portion 212 of the pixel electrode 210 may be referred to as an inclined portion of the pixel electrode 210. In an embodiment, the pixel electrode 210 may further include a third portion 213 disposed on the upper surface of the third via insulating layer 120. As the pixel electrode 210 includes the second portion 212 that is inclined, the light efficiency of the display apparatus 1 may be improved.

The pixel electrode 210 may include a conductive oxide such as, for example, indium tin oxide (ITO), indium zinc oxide (IZO), zinc oxide (ZnOₓ), indium oxide (In₂O₃), indium gallium oxide (IGO), or aluminium zinc oxide (AZO). In an embodiment, the pixel electrode 210 may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a compound thereof.

The display apparatus 1 may include a pixel defining layer 130 disposed on the third via insulating layer 120 and the pixel electrode 210. The pixel defining layer 130 may be arranged between the pixel electrode 210 and the counter electrode 230. The pixel defining layer 130 may define an opening 130OP that exposes the central portion of the pixel electrode 210. The pixel defining layer 130 may cover the second portion 212 of the pixel electrode 210 and expose at least a portion of the first portion 211 of the pixel electrode 210. In an embodiment, the pixel defining layer 130 may cover the second portion 212 and the third portion 213 of the pixel electrode 210 and an upper surface of the insulating layer IS. The pixel defining layer 130 may cover the inclined portion ISS of the insulating layer IS. That is, the pixel defining layer 130 may overlap with the inclined portion ISS of the insulating layer IS.

The opening 130OP of the pixel defining layer 130 may define an emission area of light emitted from the organic light-emitting diode OLED. For example, the size/width of the opening 130OP of the pixel defining layer 130 may correspond to the size/width of the emission area.

The pixel defining layer 130 may include an organic insulating material and/or an inorganic insulating material. The pixel defining layer 130 may include a colorant such as, for example, an organic dye or an inorganic pigment.

In an embodiment, the pixel defining layer 130 may transmit light in a wavelength range, emitted from the emission layer 220 of the organic light-emitting diode OLED. For example, the pixel defining layer 130 may transmit red light from the organic light-emitting diode OLED that emits red light, green light from the organic light-emitting diode OLED that emits green light, and blue light from the organic light-emitting diode OLED that emits blue light.

In an embodiment, the organic light-emitting diode OLED emitting red light may have a first peak wavelength within a first wavelength range, the organic light-emitting diode OLED emitting green light may have a second peak wavelength within the second wavelength range, and the organic light-emitting diode OLED emitting blue light may have a third peak wavelength within the third wavelength range. For example, the first wavelength range may be about 600 nm to about 630 nm. For example, the second wavelength range may be about 510 nm to about 540 nm. For example, the third wavelength range may be about 440 nm to about 470 nm.

The pixel defining layer 130 may include a material (e.g., a colorant) having a maximum absorption wavelength (λmax) outside each of the first wavelength range, the second wavelength range, and the third wavelength range. In other words, the pixel defining layer 130 may transmit light in the first wavelength range of about 600 nm to about 630 nm, light in the second wavelength range of about 510 nm to about 540 nm, and light in the third wavelength range of about 440 nm to about 470 nm. For example, the pixel defining layer 130 may be referred to as a colored pixel defining layer or a light-absorbing pixel defining layer. For example, the pixel defining layer 130 may include, for example, a phthalocyanine-based compound, boron-dipyrromethene (BODIPY), or a tetraazaporphyrin-based compound.

In an embodiment, the pixel defining layer 130 may include a material (e.g., a colorant) having a maximum absorption wavelength in a fourth wavelength range between the first wavelength range and the second wavelength range. For example, the pixel defining layer 130 may include a material (e.g., a colorant) having a maximum absorption wavelength in a wavelength range identical to or similar to a peak wavelength of a Y-bar function. The Y-bar function (Y̅(λ)) is a luminous efficiency function, with a peak wavelength of approximately 555 nm. For example, the pixel defining layer 130 may include a material (e.g., a colorant) having a maximum absorption wavelength in a range of about 550 nm to about 600 nm. For example, the pixel defining layer 130 may include a material (e.g., a colorant) having a maximum absorption wavelength in a range of about 570 nm to about 600 nm. For example, the pixel defining layer 130 may include a material (e.g., a colorant) having a maximum absorption wavelength in a range of about 580 nm to about 600 nm. For example, the pixel defining layer 130 may include a tetraazaporphyrin-based compound, or the like.

In the case of a comparative example in which the second portion 212 of the pixel electrode 210 is included and the pixel defining layer 130 does not include a material having a maximum absorption wavelength (λmax) outside each of the first wavelength range, the second wavelength range, and the third wavelength range, the front light efficiency is improved, but external light reflection may increase due to the inclined second portion 212 of the pixel electrode 210. For example, in the case of the comparative example in which the second portion 212, which is an inclined portion of the pixel electrode 210, is included and the pixel defining layer 130 is a black pixel defining layer including a material such as carbon black or iron oxide, external light reflection may increase.

In contrast, in the case of an embodiment in which the pixel defining layer 130 includes a material having a maximum absorption wavelength (λmax) outside each of the first wavelength range, the second wavelength range, and the third wavelength range, external light reflection may be reduced while improving the front light efficiency, thereby improving the display quality of the display apparatus 1. In particular, in an embodiment in which the pixel defining layer 130 includes a material having a maximum absorption wavelength in a wavelength range identical to or similar to the peak wavelength of the Y-bar function (for example, a material having a maximum absorption wavelength in a range of about 550 nm to about 600 nm), the front light efficiency may be improved while significantly reducing external light reflection.

The emission layer 220 may be arranged on the pixel electrode 210. In an embodiment, the emission layer 220 may be positioned within the opening 130OP of the pixel defining layer 130. The emission layer 220 may include a polymer or low-molecular weight organic material that emits light of a predetermined color. Alternatively, the emission layer 220 may include an inorganic light-emitting material or quantum dots. The emission layer 220 may be arranged on the pixel electrode 210 and emit light.

In an embodiment, the organic light-emitting diode OLED may further include a first functional layer and a second functional layer respectively disposed below and above the emission layer 220. The first functional layer may include, for example, a hole transport layer (HTL) and/or a hole injection layer (HIL). The second functional layer may be a component positioned on the emission layer 220 and may include an electron transport layer (ETL) and/or an electron injection layer (EIL). The first functional layer and/or the second functional layer may be a common layer formed to entirely cover the substrate 100, similar to the counter electrode 230 described herein.

The counter electrode 230 may be arranged over the pixel electrode 210 and overlap with the pixel electrode 210. The counter electrode 230 may be arranged on the emission layer 220. The counter electrode 230 may include a conductive material having a low work function. For example, the counter electrode 230 may include a (semi)transparent layer including silver (Ag), magnesium (Mg), aluminium (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the counter electrode 230 may further include a layer such as, for example, ITO, IZO, ZnO or In₂O₃ on the (semi)transparent layer including the material described herein. The counter electrode 230 may be formed integrally to entirely cover the substrate 100.

The encapsulation layer 300 may be arranged on the counter electrode 230. The encapsulation layer 300 may be arranged on the organic light-emitting diode OLED and cover the organic light-emitting diode OLED. The encapsulation layer 300 may include at least one inorganic encapsulation layer and at least one organic encapsulation layer, and as an embodiment, FIG. 3 illustrates the encapsulation layer 300 including a first inorganic encapsulation layer 310, an organic encapsulation layer 320, and a second inorganic encapsulation layer 330 that are sequentially stacked.

Each of the first inorganic encapsulation layer 310 and the second inorganic encapsulation layer 330 may include one or more inorganic materials selected from aluminium oxide, titanium oxide, tantalum oxide, hafnium oxide, zinc oxide, silicon oxide, silicon nitride, and silicon oxynitride.

The organic encapsulation layer 320 may include a polymer-based material. The polymer-based material may include an acrylic resin, an epoxy-based resin, polyimide, polyethylene, and the like. In an embodiment, the organic encapsulation layer 320 may include acrylate. The organic encapsulation layer 320 may be formed by curing a monomer or applying a polymer. The organic encapsulation layer 320 may have transparency.

The touch sensor layer 400 may be disposed on the encapsulation layer 300. The touch sensor layer 400 may detect an external input, such as, for example, a touch of an object such as a finger or a stylus pen, thereby allowing the display apparatus 1 to obtain coordinate information corresponding to a touch location. The touch sensor layer 400 may include a touch electrode and trace lines connected to the touch electrode. The touch sensor layer 400 may detect an external input by using a mutual cap method or a self cap method.

In an embodiment, the touch sensor layer 400 may be formed directly on the encapsulation layer 300. Alternatively, the touch sensor layer 400 may be formed separately and then adhered to the encapsulation layer 300 through an adhesive layer such as, for example, an optically clear adhesive (OCA).

The polarization layer 500 may reduce the reflectance of light (external light) incident from the outside toward the display apparatus 1 and/or improve the color purity of light emitted from the display apparatus 1. In an embodiment, the polarization layer 500 may include a phase retarder and/or a polarizer. The phase retarder may be of film type or liquid crystal coating type, and may include a λ/2 phase retarder and/or a λ/4 phase retarder. The polarizer may also be film type or liquid crystal coating type. The film type may include a stretchable synthetic resin film, and the liquid crystal coating type may include liquid crystals arranged in a predetermined array. The retarder and the polarizer may further include a protective film.

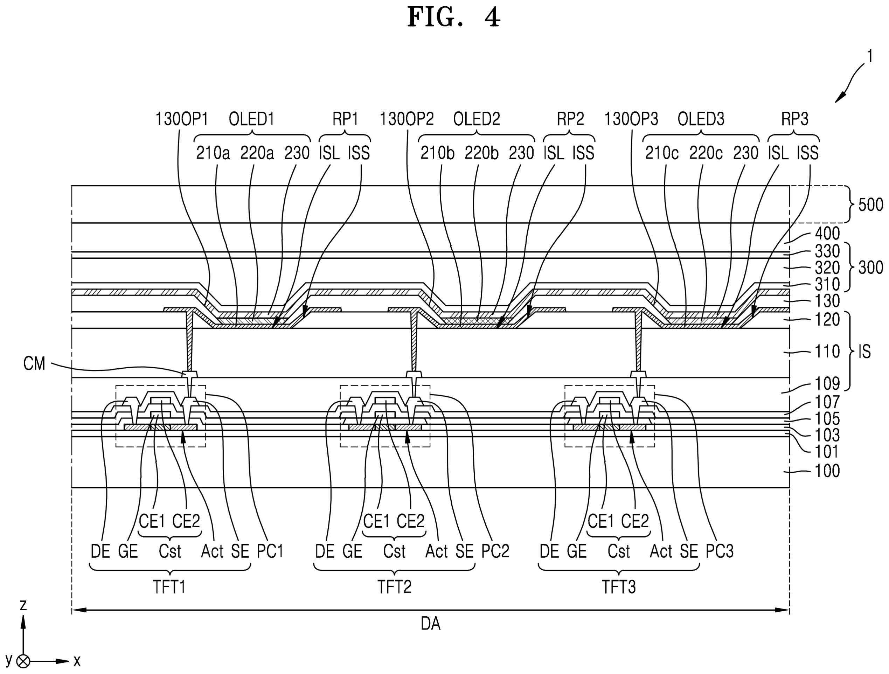

FIG. 4 is a cross-sectional view schematically illustrating a display area of a display apparatus according to an embodiment.

FIG. 4 illustrates a first organic light-emitting diode OLED1, a second organic light-emitting diode OLED2, a third organic light-emitting diode OLED3, a first pixel circuit PC1, a second pixel circuit PC2, and a third pixel circuit PC3 arranged in a display area of a display apparatus according to an embodiment. The first organic light-emitting diode OLED1, the second organic light-emitting diode OLED2, and the third organic light-emitting diode OLED3 of FIG. 4 have the same or similar structure as the organic light-emitting diode OLED of FIG. 3, and the first pixel circuit PC1, the second pixel circuit PC2, and the third pixel circuit PC3 of FIG. 4 have the same or similar structure as the pixel circuit PC of FIG. 3, and thus the description of the organic light-emitting diode OLED and the pixel circuit PC of FIG. 3 is applied equally, and the description of the details with reference to FIG. 4 that is substantially the same as that given with reference to FIG. 3 is omitted.

Referring to FIG. 4, the display apparatus 1 may include the first organic light-emitting diode OLED1, the second organic light-emitting diode OLED2, and the third organic light-emitting diode OLED3 that emit light of different wavelength ranges. In an embodiment, the first organic light-emitting diode OLED1 may emit light of a red wavelength, the second organic light-emitting diode OLED2 may emit light of a green wavelength, and the third organic light-emitting diode OLED3 may emit light of a blue wavelength.

The first pixel circuit PC1 may be electrically connected to the first organic light-emitting diode OLED1, the second pixel circuit PC2 may be electrically connected to the second organic light-emitting diode OLED2, and the third pixel circuit PC3 may be electrically connected to the third organic light-emitting diode OLED3. The first pixel circuit PC1 may include a first thin film transistor TFT1 and the storage capacitor Cst, the second pixel circuit PC2 may include a second thin film transistor TFT2 and the storage capacitor Cst, and the third pixel circuit PC3 may include a third thin film transistor TFT3 and the storage capacitor Cst. Each of the first thin film transistor TFT1, the second thin film transistor TFT2, and the third thin film transistor TFT3 may include the semiconductor layer Act, the gate electrode GE, the drain electrode DE, and the source electrode SE.

The insulating layer IS may include a plurality of recessed portions RP. For example, the insulating layer IS may include a first recessed portion RP1, a second recessed portion RP2, and a third recessed portion RP3. Each of the first recessed portion RP1, the second recessed portion RP2, and the third recessed portion RP3 may include the bottom surface portion ISL formed by the upper surface of the second via insulating layer 110 and the inclined portion ISS formed by the inclined surface of the third via insulating layer 120.

The first organic light-emitting diode OLED1 may include a first pixel electrode 210a, a first emission layer 220a, and the counter electrode 230. The second organic light-emitting diode OLED2 may include a second pixel electrode 210b, a second emission layer 220b, and the counter electrode 230. The third organic light-emitting diode OLED3 may include a third pixel electrode 210c, a third emission layer 220c, and the counter electrode 230.

The first organic light-emitting diode OLED1 may be arranged on the first recessed portion RP1, the second organic light-emitting diode OLED2 may be arranged on the second recessed portion RP2, and the third organic light-emitting diode OLED3 may be arranged on the third recessed portion RP3.

The first pixel electrode 210a, the second pixel electrode 210b, and the third pixel electrode 210c may be arranged spaced apart from each other on the insulating layer IS. For example, at least a portion of the first pixel electrode 210a may be disposed on the first recessed portion RP1, at least a portion of the second pixel electrode 210b may be disposed on the second recessed portion RP2, and at least a portion of the third pixel electrode 210c may be disposed on the third recessed portion RP3. For example, at least a portion of the first pixel electrode 210a may be disposed on the bottom surface portion ISL and the inclined portion ISS of the first recessed portion RP1, at least a portion of the second pixel electrode 210b may be disposed on the bottom surface portion ISL and the inclined portion ISS of the second recessed portion RP2, and at least a portion of the third pixel electrode 210c may be disposed on the bottom surface portion ISL and the inclined portion ISS of the third recessed portion RP3.

The first organic light-emitting diode OLED1 may be electrically connected to the first thin film transistor TFT1 through contact holes formed in the insulating layer IS (e.g., the first via insulating layer 109, the second via insulating layer 110, and the third via insulating layer 120) and through the connection electrode CM. The second organic light-emitting diode OLED2 may be electrically connected to the second thin film transistor TFT2 through contact holes formed in the insulating layer IS (e.g., the first via insulating layer 109, the second via insulating layer 110, and the third via insulating layer 120) and through the connection electrode CM. The third organic light-emitting diode OLED3 may be electrically connected to the third thin film transistor TFT3 through contact holes formed in the insulating layer IS (e.g., the first via insulating layer 109, the second via insulating layer 110, and the third via insulating layer 120) and through the connection electrode CM.

The pixel defining layer 130 may be arranged between the first pixel electrode 210a and the counter electrode 230, between the second pixel electrode 210b and the counter electrode 230, and between the third pixel electrode 210c and the counter electrode 230.

The pixel defining layer 130 may define a first opening 130OP1 exposing the central portion of the first pixel electrode 210a, a second opening 130OP2 exposing the central portion of the second pixel electrode 210b, and a third opening 130OP3 exposing the central portion of the third pixel electrode 210c. The pixel defining layer 130 may cover the second portion (212, see FIG. 3) and the third portion (213, see FIG. 3) of the first pixel electrode 210a, the second portion (212, see FIG. 3) and the third portion (213, see FIG. 3) of the second pixel electrode 210b, and the second portion (212, see FIG. 3) and the third portion (213, see FIG. 3) of the third pixel electrode 210c. The pixel defining layer 130 may expose at least a portion of the first portion (211, see FIG. 3) of the first pixel electrode 210a, at least a portion of the first portion (211, see FIG. 3) of the second pixel electrode 210b, and at least a portion of the first portion (211, see FIG. 3) of the third pixel electrode 210c. In an embodiment, the pixel defining layer 130 may cover the second portion (212, see FIG. 3) and the third portion (213, see FIG. 3) of each of the first pixel electrode 210a, the second pixel electrode 210b, and the third pixel electrode 210c, and the upper surface of the insulating layer IS. The pixel defining layer 130 may cover the inclined portion ISS of each of the first recessed portion RP1, the second recessed portion RP2, and the third recessed portion RP3. That is, the pixel defining layer 130 may overlap with the inclined portion ISS of each of the first recessed portion RP1, the second recessed portion RP2, and the third recessed portion RP3.

The first opening 130OP1 of the pixel defining layer 130 may define a first emission area of light emitted from the first organic light-emitting diode OLED1. The second opening 130OP2 of the pixel defining layer 130 may define a second emission area of light emitted from the second organic light-emitting diode OLED2. The third opening 130OP3 of the pixel defining layer 130 may define a third emission area of light emitted from the third organic light-emitting diode OLED3.

In an embodiment, the first organic light-emitting diode OLED1 emitting red light may have a first peak wavelength in a range from about 600 nm to about 630 nm, the second organic light-emitting diode OLED2 emitting green light may have a second peak wavelength in a range from about 510 nm to about 540 nm, and the third organic light-emitting diode OLED3 emitting blue light may have a third peak wavelength in a range from about 440 nm to about 470 nm.

The first emission layer 220a, the second emission layer 220b, and the third emission layer 220c may emit light of different wavelength ranges. For example, the first emission layer 220a may emit light of a red wavelength, the second emission layer 220b may emit light of a green wavelength, and the third emission layer 220c may emit light of a blue wavelength. The first to third emission layers 220a, 220b, and 220c may be patterned and provided for respective organic light-emitting diodes.

The counter electrode 230 may be arranged on the first to third pixel electrodes 210a, 210b, and 210c and positioned opposite each of the first to third pixel electrodes 210a, 210b, and 210c. The counter electrode 230 may be formed as a single body on the substrate 100, unlike the first to third pixel electrodes 210a, 210b, and 210c which are each spaced apart from each other and patterned. The counter electrode 230 may be arranged across a plurality of organic light-emitting diodes including the first organic light-emitting diode OLED1, the second organic light-emitting diode OLED2, and the third organic light-emitting diode OLED3 located in the display area DA.

A method of manufacturing the display apparatus 1, according to an embodiment, may include: forming the first pixel circuit PC1, the second pixel circuit PC2, and the third pixel circuit PC3 on the substrate 100; forming the insulating layer IS including the first recessed portion RP1, the second recessed portion RP2, and the third recessed portion RP3 each including the bottom surface portion ISL and the inclined portion ISS, respectively on the first pixel circuit PC1, the second pixel circuit PC2, and the third pixel circuit PC3; forming the first pixel electrode 210a, the second pixel electrode 210b, and the third pixel electrode 210c on the first recessed portion RP1, the second recessed portion RP2, and the third recessed portion RP3, respectively; forming the pixel defining layer 130 defining the first opening 130OP1 exposing the center portion of the first pixel electrode 210a, the second opening 130OP2 exposing the center portion of the second pixel electrode 210b, and the third opening 130OP3 exposing the center portion of the third pixel electrode 210c; forming the first emission layer 220a on the first pixel electrode 210a; forming the second emission layer 220b on the second pixel electrode 210b; forming the third emission layer 220c on the third pixel electrode 210c; and forming the counter electrode 230 on the first emission layer 220a, the second emission layer 220b, and the third emission layer 220c.

In an embodiment, the pixel defining layer 130 may include a material having a maximum absorption wavelength (λmax) outside each of the first wavelength range, the second wavelength range, and the third wavelength range. For example, the pixel defining layer 130 may include a phthalocyanine-based compound, BODIPY, or a tetraazaporphyrin-based compound.

In an embodiment, the pixel defining layer 130 may include a material having a maximum absorption wavelength in the fourth wavelength range between the first wavelength range and the second wavelength range. For example, the pixel defining layer 130 may include a material having a maximum absorption wavelength in a wavelength range adjacent to the peak wavelength of the Y-bar function. The Y-bar function (Y̅(λ)) is a luminous efficiency function, with a peak wavelength of approximately 555 nm. For example, the pixel defining layer 130 may include a material having a maximum absorption wavelength in a range of about 550 nm to about 600 nm. For example, the pixel defining layer 130 may include a tetraazaporphyrin-based compound, or the like.

In an embodiment, the forming of the pixel defining layer 130 may include forming a preliminary pixel defining layer entirely on the first pixel electrode 210a, the second pixel electrode 210b, the third pixel electrode 210c, and the third via insulating layer 120, and then removing a portion of an area corresponding to each of the first pixel electrode 210a, the second pixel electrode 210b, and the third pixel electrode 210c to form the first opening 130OP1, the second opening 130OP2, and the third opening 130OP3. Portions of the pixel defining layer 130, which respectively correspond to the first organic light-emitting diode OLED1, the second organic light-emitting diode OLED2, and the third organic light-emitting diode OLED3, may be formed simultaneously. That is, the portions of the pixel defining layer 130 respectively corresponding to the first organic light-emitting diode OLED1, the second organic light-emitting diode OLED2, and the third organic light-emitting diode OLED3 may include the same material.

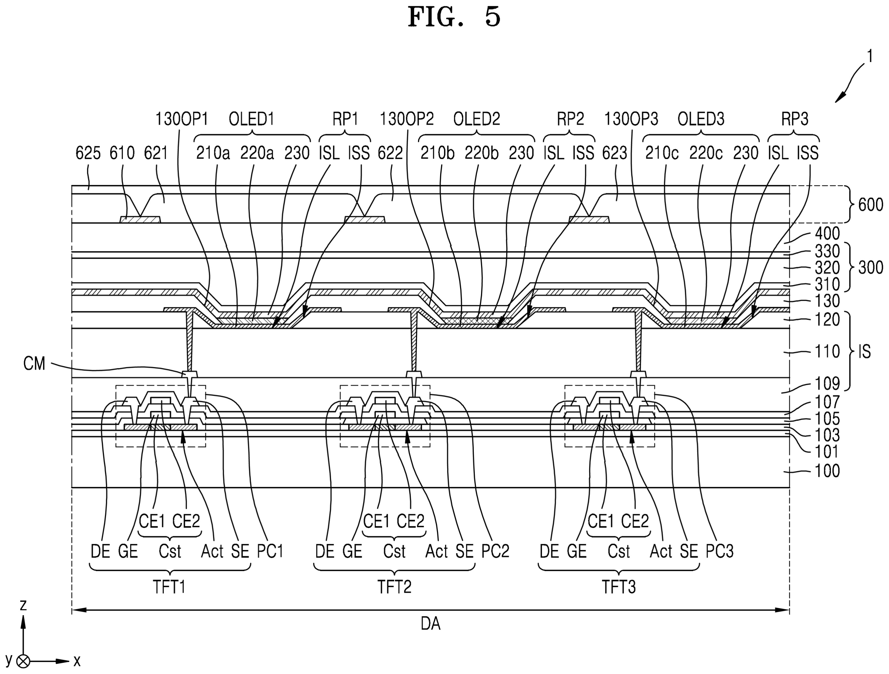

FIG. 5 is a cross-sectional view schematically illustrating a display area of a display apparatus according to an embodiment.

FIG. 5 illustrates the first organic light-emitting diode OLED1, the second organic light-emitting diode OLED2, the third organic light-emitting diode OLED3, the first pixel circuit PC1, the second pixel circuit PC2, and the third pixel circuit PC3 arranged in a display area of a display apparatus according to an embodiment. Descriptions of the same components and structures in FIG. 5 as those of FIG. 4 will be omitted and description will be focused on the difference.

Referring to FIG. 5, the display apparatus 1 may further include a color filter layer 600 on the encapsulation layer 300. In an embodiment, the touch sensor layer 400 may be disposed on the encapsulation layer 300, and the color filter layer 600 may be disposed on the touch sensor layer 400.

The color filter layer 600 may include a light-blocking layer 610 and a color filter (e.g., a first color filter 621, a second color filter 622, and a third color filter 623). In an embodiment, the color filter layer 600 may further include an overcoat layer 625 disposed on the color filter.

The light-blocking layer 610 may include a material configured to block light. For example, the light-blocking layer 610 may include an organic material having high light absorption rate. The light-blocking layer 610 may include a black pigment or a black dye. The light-blocking layer 610 may include a photosensitive organic material and include, for example, a coloring agent such as a pigment or dye.

The color filter layer 600 may include the first color filter 621, the second color filter 622, and the third color filter 623 respectively corresponding to the first organic light-emitting diode OLED1, the second organic light-emitting diode OLED2, and the third organic light-emitting diode OLED3. The first color filter 621, the second color filter 622, and the third color filter 623 may have colors respectively corresponding to light emitted from the first organic light-emitting diode OLED1, the second organic light-emitting diode OLED2, and the third organic light-emitting diode OLED3. In an embodiment, when the first organic light-emitting diode OLED1 emits red light, the first color filter 621 may be a red color filter, when the second organic light-emitting diode OLED2 emits green light, the second color filter 622 may be a green color filter, and when the third organic light-emitting diode OLED3 emits blue light, the third color filter 623 may be a blue color filter. The light-blocking layer 610 may be arranged between adjacent color filters.

The overcoat layer 625 may be arranged on the light-blocking layer 610 and the color filters. The overcoat layer 625 may be a colorless, light-transmitting layer that does not have a color in the visible light band and may flatten an upper surface of the light-blocking layer 610 and an upper surface of the color filter. The overcoat layer 625 may include a colorless, light-transmitting organic material such as, for example, an acrylic resin.

In an embodiment, as the pixel defining layer 130 includes a colorant rather than a black pixel defining layer, light extraction efficiency may be increased while reducing external light reflection. Accordingly, the display apparatus 1 may include the color filter layer 600 of FIG. 5 instead of the polarization layer 500 of FIG. 4. That is, the display apparatus 1 may include the color filter layer 600 while having applied thereto a structure of the pixel electrode 210 including the second portion (212, see FIG. 3) that is inclined from the first portion (211, see FIG. 3).

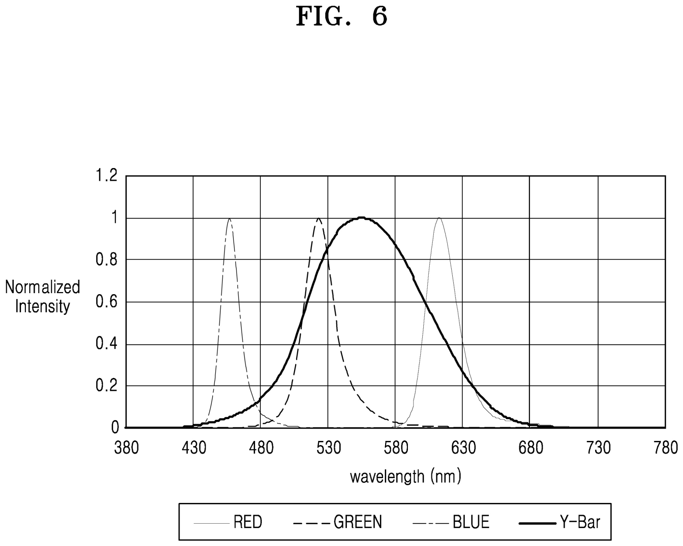

FIG. 6 is a graph illustrating emission spectra and a Y-bar function of red light, green light, and blue light according to an embodiment.

Referring to FIG. 6, the red light has a first peak wavelength within a range of about 600 nm to about 630 nm, the green light has a second peak wavelength within a range of about 510 nm to about 540 nm, and the blue light has a third peak wavelength within a range of about 440 nm to about 470 nm. The peak wavelength of the Y-bar function is approximately 555 nm, which is between the second peak wavelength of green light and the first peak wavelength of red light.

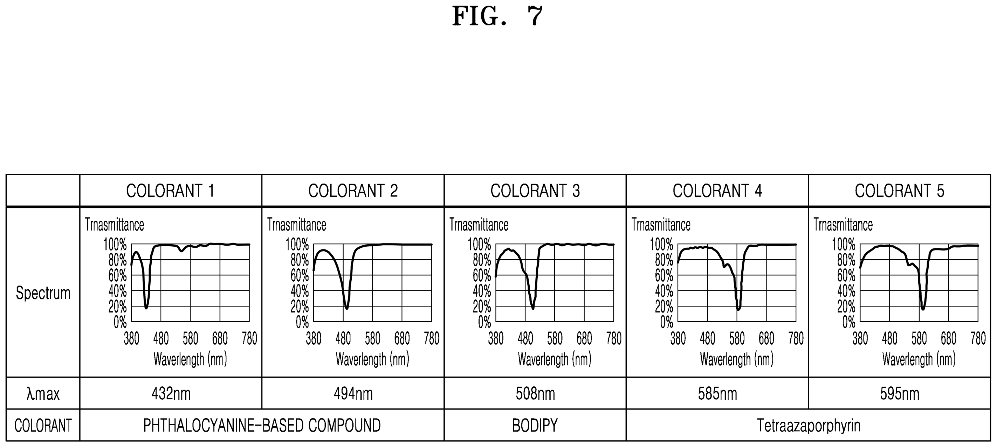

FIG. 7 is a table illustrating a maximum absorption wavelength for each colorant. Colorants 1 and 2 are each a phthalocyanine-based compound, Colorant 3 is BODIPY, and Colorants 4 and 5 are each a tetraazaporphyrin-based compound.

Referring to FIG. 7, the maximum absorption wavelength (λmax) of Colorant 1 is about 432 nm, the maximum absorption wavelength (λmax) of Colorant 2 is about 494 nm, the maximum absorption wavelength (λmax) of Colorant 3 is about 508 nm, the maximum absorption wavelength (λmax) of Colorant 4 is about 585 nm, and the maximum absorption wavelength (λmax) of Colorant 5 is about 595 nm.

Referring to FIGS. 6 and 7 together, each of Colorant 1, Colorant 2, Colorant 3, Colorant 4, and Colorant 5 has a maximum absorption wavelength outside each of the first wavelength range of about 600 nm to about 630 nm having a first peak wavelength of red light, the second wavelength range of about 510 nm to about 540 nm having a second peak wavelength of green light, and a third peak wavelength range of about 440 nm to about 470 nm having a third peak wavelength of blue light. Each of colorants 4 and 5 has a maximum absorption wavelength between the first wavelength range of about 600 nm to about 630 nm having a first peak wavelength of red light and the second wavelength range of about 510 nm to about 540 nm having a second peak wavelength of green light. Colorants 4 and 5 each have a maximum absorption wavelength in a wavelength range adjacent to the peak wavelength of the Y-bar function (e.g., about 555 nm) (e.g., in a range from about 550 nm to about 600 nm).

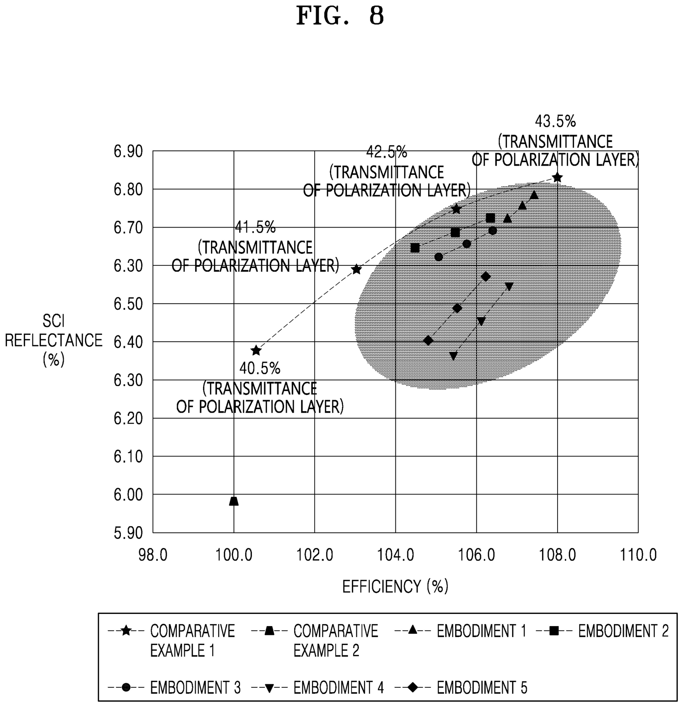

FIG. 8 is a graph illustrating Specular Component Included (SCI) reflectance versus the light efficiency of comparative examples and embodiments. Comparative Example 1 is a display apparatus including a black pixel defining layer that does not include a colorant, and Embodiments 1, 2, 3, 4, and 5 are display apparatuses including a pixel defining layer including Colorant 1, Colorant 2, Colorant 3, Colorant 4, and Colorant 5 of FIG. 7, respectively. Comparative Example 1, Embodiment 1, Embodiment 2, Embodiment 3, Embodiment 4, and Embodiment 5 are display apparatuses including an insulating layer including a recessed portion including a bottom surface portion and an inclined portion, and a pixel electrode disposed on the recessed portion and having a structure including an inclined portion. Comparative Example 2 is a display apparatus in which a pixel electrode does not include an inclined portion because an insulating layer does not include an inclined portion.

The light efficiencies of Comparative Example 1 and Embodiments 1 to 5 of FIG. 8 are based on the light efficiency of Comparative Example 2 being 100%. Comparative Example 1 and Embodiments 1 to 5 may be confirmed to have improved light efficiency as a pixel electrode includes an inclined portion, compared to Comparative Example 2 which does not include an inclined portion.

FIG. 8 illustrates the reflectance versus light efficiency according to the adjustment of the transmittance of a polarization layer of Comparative Example 1. FIG. 8 illustrates the reflectance versus light efficiency according to the concentration of a colorant included in the pixel defining layer in each of Embodiments 1, 2, 3, 4, and 5.

Referring to FIG. 8, it may be confirmed that when the transmittance of the polarization layer is reduced in order to reduce the reflectance in Comparative Example 1, the decrease in light efficiency occurs more significantly than the effect of reducing the reflectance.

In each of Embodiments 1, 2, 3, 4, and 5, it may be confirmed that the reflectance is reduced compared to Comparative Example 1, when the light efficiency is in the range of about 104 % to 108 %. In particular, in the case of Embodiments 4 and 5, it may be confirmed that the reflectance at the same light efficiency is significantly reduced compared to Comparative Example 1, and it may also be confirmed that the reflectance at the same light efficiency is reduced compared to Embodiments 1, 2, and 3.

That is, rather than including a black pixel defining layer and reducing the transmittance of the polarization layer as in Comparative Example 1, when including a pixel defining layer including a colorant having a maximum absorption wavelength outside each of the first wavelength range of about 600 nm to about 630 nm having a first peak wavelength of red light, the second wavelength range of about 510 nm to about 540 nm having a second peak wavelength of green light, and the third peak wavelength range of about 440 nm to about 470 nm having a third peak wavelength of blue light as in the embodiments, the reflectance may be reduced more effectively. In Embodiments 1 to 5 respectively including Colorants 1 to 5, the light efficiency may be improved while relatively reducing reflectance.

When a material having a maximum absorption wavelength in the range of about 550 nm to about 600 nm is included, as in Embodiments 4 and 5, the reflectance may be reduced more significantly. For example, in Embodiments 4 and 5 each including a tetraazaporphyrin compound, the light efficiency may be improved while significantly reducing reflectance.

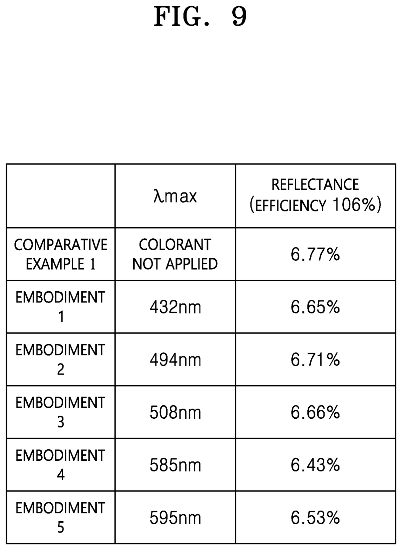

FIG. 9 is a table illustrating reflectance and maximum absorption wavelength when the light efficiency of the comparative examples and the embodiments of FIG. 8 is 106%.

Referring to FIG. 9, when the light efficiency was 106%, the reflectance of Comparative Example 1 was 6.77%. When the light efficiency was 106%, the reflectance of Embodiment 1 was 6.65%, the reflectance of Embodiment 2 was 6.71%, the reflectance of Embodiment 3 was 6.66%, the reflectance of Embodiment 4 was 6.43%, and the reflectance of Embodiment 5 was 6.53%.

Embodiment 1 showed a 0.12% decrease in reflectance compared to Comparative Example 1, Embodiment 2 showed a 0.06% decrease in reflectance compared to Comparative Example 1, Embodiment 3 showed a 0.11% decrease in reflectance compared to Comparative Example 1, Embodiment 4 showed a 0.34% decrease in reflectance compared to Comparative Example 1, and Embodiment 5 showed a 0.24% decrease in reflectance compared to Comparative Example 1. That is, under the same light efficiency conditions, it may be confirmed that the reflectance is reduced in Embodiments 1 to 5 including a colorant compared to Comparative Example 1 that does not include a colorant.

In particular, it may be confirmed that the reflectance of Embodiments 4 and 5 was significantly reduced by more than 0.2% compared to Comparative Example 1. In some aspects, Embodiment 4 had a reflectance decrease of 0.23% to 0.28% compared to Embodiments 1, 2, and 3, and Embodiment 5 had a reflectance decrease of 0.12% to 0.18% compared to Embodiments 1, 2, and 3.

The display apparatus 1 according to the embodiment may be applied to various electronic apparatuses. An electronic apparatus according to an embodiment may include the display apparatus 1 described herein, and may further include a module or device having additional functions in addition to the display apparatus 1.

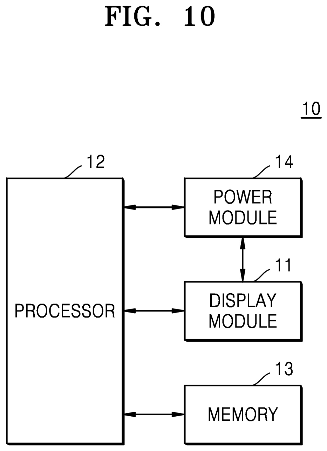

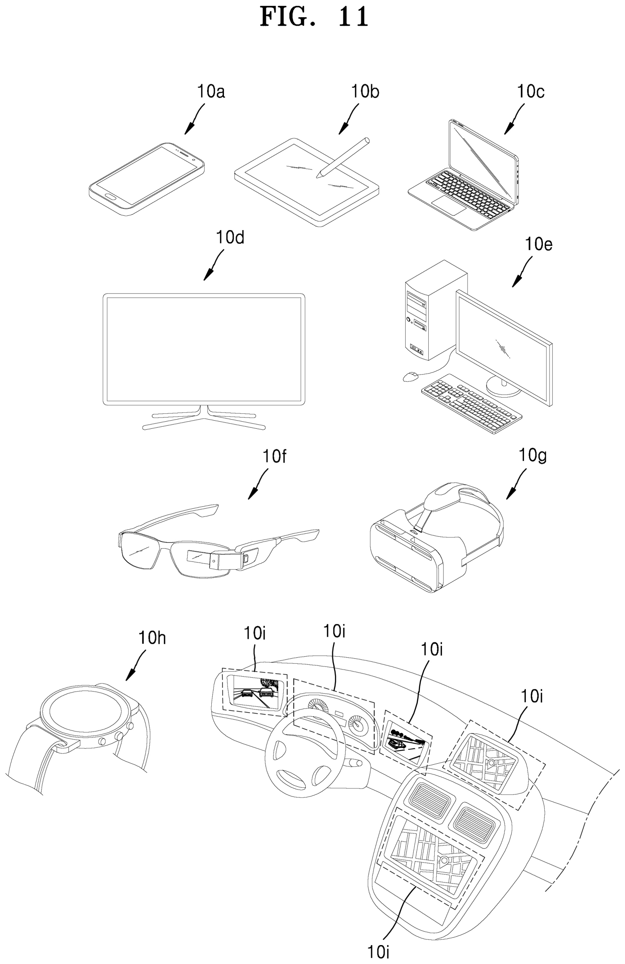

FIG. 10 is a block diagram of an electronic apparatus according to an embodiment. FIG. 11 is a schematic diagram illustrating various electronic apparatuses according to one or more embodiments of the present disclosure.

Referring to FIG. 10, an electronic apparatus 10 according to an embodiment may include a display module 11, a processor 12, a memory 13, and a power module 14.

The display module 11 may include a display apparatus (1, see FIG. 3) according to an embodiment.

The processor 12 may include at least one of a central processing unit (CPU), an application processor (AP), a graphics processing unit (GPU), a communication processor (CP), an image signal processor (ISP), and a controller.

Data information supportive of the operation of the processor 12 or the display module 11 may be stored in the memory 13. In an example in which the processor 12 executes an application stored in the memory 13, an image data signal and/or an input control signal may be transmitted to the display module 11, and the display module 11 may process the received signal and output image information through a display screen.

The power module 14 may include a power supply module, such as, for example, a power adapter or a battery device, and a power conversion module that converts power supplied by the power supply module to generate power for the operation of the electronic apparatus 10.

At least one of the components of the electronic apparatus 10 described herein may be included in a display apparatus including the display module 11. In some aspects, some of the modules mentioned above may be included within the display apparatus, while others may be provided separately from the display apparatus. For example, the display apparatus may include the display module 11, and the processor 12, the memory 13 and the power module 14 may be provided in the form of other apparatuses within the electronic apparatus 10 other than the display apparatus.

Referring to FIG. 11, various electronic apparatuses including a display apparatus (1, see FIG. 3) according to embodiments may include not only image display electronic apparatuses such as a smartphone 10a, a tablet PC 10b, a laptop 10c, a TV 10d, a desk monitor 10e, but also wearable electronic apparatuses including display modules such as smart glasses 10f, a head mounted display 10g, a smart watch 10h, and the like, and a vehicle electronic apparatus 10i including display modules such as a Center Information Display (CID) arranged on a dashboard, and/or a center fascia of an automobile, an instrument panel of an automobile, a room mirror display, and the like.

As such, the disclosure has been described with reference to an embodiment illustrated in the drawings, but this is an example, and those skilled in the art will understand that various modifications and variations of the embodiment may be made therefrom. Thus, the technical scope of the disclosure should be determined by the appended claims.

A display apparatus and an electronic apparatus including the display apparatus according to an embodiment may have improved display quality by improving light efficiency and reducing external light reflection. The above-described effects are an example, and the scope of the disclosure is not limited by these effects.

It should be understood that embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (1) comprising:
a substrate (100);
an insulating layer (IS) disposed on the substrate (100) and comprising a recessed portion (RP) comprising an inclined portion (ISS) and a bottom surface portion (ISL);
a plurality of light-emitting diodes (OLED) each comprising a pixel electrode (210) having at least a portion disposed on the inclined portion (ISS) of the recessed portion (RP) of the insulating layer (IS), an emission layer (220) on the pixel electrode (210), and a counter electrode (230) on the emission layer (220); and
a pixel defining layer (130) disposed between the pixel electrode (210) and the counter electrode (230) and covering a portion of the pixel electrode (210),
wherein:
the plurality of light-emitting diodes (OLED) comprise a first light-emitting diode (OLED1) emitting red light having a first peak wavelength within a first wavelength range, a second light-emitting diode (OLED2) emitting green light having a second peak wavelength within a second wavelength range, and a third light-emitting diode (OLED3) emitting blue light having a third peak wavelength within a third wavelength range, and
the pixel defining layer (130) comprises a material having a maximum absorption wavelength outside each of the first wavelength range, the second wavelength range, and the third wavelength range.

2. The display apparatus (1) of claim 1, wherein the pixel defining layer (130) comprises a material having a maximum absorption wavelength in a fourth wavelength range between the first wavelength range and the second wavelength range.

3. The display apparatus (1) of claim 2, wherein the fourth wavelength range is about 550 nm to about 600 nm.

4. The display apparatus (1) of any one of claims 1 to 3, wherein the pixel defining layer comprises a phthalocyanine-based compound, boron-dipyrromethene, or a tetraazaporphyrin-based compound.

5. The display apparatus (1) of any one of claims 1 to 4, wherein the first wavelength range is about 600 nm to about 630 nm.

6. The display apparatus (1) of any one of claims 1 to 5, wherein:
(i) the second wavelength range is about 510 nm to about 540 nm; and/or
(ii) the third wavelength range is about 440 nm to about 470 nm.

7. The display apparatus (1) of any one of claims 1 to 6, further comprising:
(i) an encapsulation layer (300) disposed on the first light-emitting diode (OLED1), the second light-emitting diode (OLED2), and the third light-emitting diode (OLED3); and
a polarization layer (500) disposed on the encapsulation layer (300); or
(ii) an encapsulation layer (300) disposed on the first light-emitting diode (OLED1), the second light-emitting diode (OLED2), and the third light-emitting diode (OLED3); and
a color filter layer (600) disposed on the encapsulation layer (300).

8. The display apparatus (1) of any one of claims 1 to 7, wherein:
the pixel electrode (210) comprises a first portion (211) disposed on the bottom surface portion (ISL) of the recessed portion (RP) and a second portion (212) disposed on the inclined portion (ISS), and
the pixel defining layer (230) covers the second portion (212) and exposes at least a portion of the first portion (211).

9. A display apparatus (1) comprising:
a substrate (100);
an insulating layer (IS) disposed on the substrate (100) and comprising a recessed portion (RP) comprising an inclined portion (ISS) and a bottom surface portion (ISL);
a pixel electrode (210) comprising a first portion (211) arranged on the bottom surface portion (ISL) and a second portion (212) arranged on the inclined portion (ISS);
a pixel defining layer (130) covering the second portion (212) of the pixel electrode (210) and defining an opening (130OP) exposing at least a portion of the first portion (211) of the pixel electrode (210);
an emission layer (220) disposed on the pixel electrode (210); and
a counter electrode (230) disposed on the emission layer (220),
wherein the pixel defining layer (130) transmits light in a first wavelength range of about 600 nm to about 630 nm, light in a second wavelength range of about 510 nm to about 540 nm, and light in a third wavelength range of about 440 nm to about 470 nm, and comprises a material having a maximum absorption wavelength (λmax) outside each of the first wavelength range, the second wavelength range, and the third wavelength range.

10. The display apparatus (1) of claim 9, wherein the pixel defining layer (130) comprises a material having a maximum absorption wavelength in a fourth wavelength range between the first wavelength range and the second wavelength range, optionally wherein the fourth wavelength range is about 550 nm to about 600 nm.

11. The display apparatus (1) of claim 9 or claim 10, wherein the pixel defining layer (130) comprises a phthalocyanine-based compound, boron-dipyrromethene, or a tetraazaporphyrin-based compound.

12. The display apparatus (1) of any one of claims 9 to 11, further comprising:
(i) an encapsulation layer (300) disposed on the counter electrode (230); and
a polarization layer (500) disposed on the encapsulation layer (300); or
(ii) an encapsulation layer (300) disposed on the counter electrode (230); and
a color filter layer (600) disposed on the encapsulation layer (300).

13. An electronic apparatus (10) comprising:
a display apparatus (1); and
a processor (12) which provides an image data signal and an input control signal to the display apparatus (1),
wherein the display apparatus (1) comprises:
a substrate (100);
an insulating layer (IS) disposed on the substrate (100) and comprising an inclined portion (ISS);
a plurality of light-emitting diodes (OLED) each comprising a pixel electrode (210) having at least a portion disposed on the inclined portion (ISS) of the insulating layer (IS), an emission layer (220) on the pixel electrode (210), and a counter electrode (230) on the emission layer (220); and
a pixel defining layer (130) disposed between the pixel electrode (210) and the counter electrode (230) and covering a portion of the pixel electrode (210),
wherein:
the plurality of light-emitting diodes (OLED) comprise a first light-emitting diode (OLED1) emitting red light having a first peak wavelength within a first wavelength range, a second light-emitting diode (OLED2) emitting green light having a second peak wavelength within a second wavelength range, and a third light-emitting diode (OLED3) emitting blue light having a third peak wavelength within a third wavelength range, and
the pixel defining layer (130) comprises a material having a maximum absorption wavelength outside each of the first wavelength range, the second wavelength range, and the third wavelength range.

14. The electronic apparatus (10) of claim 13, wherein:
the first wavelength range is about 600 nm to about 630 nm,
the second wavelength range is about 510 nm to about 540 nm, and
the third wavelength range is about 440 nm to about 470 nm, optionally wherein the pixel defining layer (130) comprises a material having a maximum absorption wavelength in a range of about 550 nm to about 600 nm.

15. The electronic apparatus (10) of claim 13 or claim 14, wherein the pixel defining layer (130) comprises a phthalocyanine-based compound, boron-dipyrromethene, or a tetraazaporphyrin-based compound.
